# EUROPEAN PATENT APPLICATION

(11) **EP 4 682 100 A1**
(43) Date of publication of application: **21.01.2026**
(21) Application number: 24189298.3
(22) Date of filing: 17.07.2024
(51) Int. Cl.: B81B 7/00, H01L 21/48, H01L 23/498, H01L 23/538, H01L 23/15

(54) **MULTILAYER CERAMIC ELECTRONIC DEVICE AND METHOD FOR FABRICATING A CERAMIC ELECTRONIC DEVICE, DEVICE FOR MARKING A WORK PIECE AND DEVICE FOR DETECTING AT LEAST ONE PROCESS PARAMETER**

(71) Applicant: matriq AG, 9014 St. Gallen (CH)
(72) Inventor: Dietrich, Klaus, 6844 Altach (AT); Breitenstein, Eric, 9472 Grabs (CH); Schellenberg, Edwin, 8594 Güttingen (CH); Mächler, Mathias, 9473 Gams (CH); Lüchinger, Marco, 9462 Montlingen (CH)
(74) Representative: Neuhold, Alfred

(57) **Abstract**

The invention relates to a multilayer ceramic electronic device 20 for contacting a control unit with an electric component or structure, comprising several ceramic layers 25, 30, 35, 40, 45, 50, 55, wherein said several ceramic layers forming a body and at least some of the ceramic layers comprising inner-layer conductive tracks 31, 36, 41, 46, 51 and/or at least some of the ceramic layers comprising inner-layer vertical connections 37, 42, 47, 52 to neighboring ceramic layers, at least one ceramic layer comprises at least two outer electrodes 34, 34a, 39, 44, 49, 54 disposed on a side-face 21, 24 of the at least one ceramic layer, whereby said at least two outer electrodes are horizontally shifted from each other, and are electrically connected to at least one inner-layer vertical connection of neighboring ceramic layers. At least one of the ceramic layers provides a top-layer 55 comprising several inner-layer vertical connections 56 for connecting at least one electrical component, whereby the outer electrodes 34, 34a, 39, 44, 49, 54 of the at least one ceramic layer are connected to some of the several inner-layer vertical connections 56 of the top-layer 55.

## Description

The present invention relates to a multilayer ceramic electronic device for contacting a control unit with an electric component or structure according to the generic term of claim 1 and a method for fabricating a multilayer ceramic electronic device according to the generic term of claim 10, a device for marking a work piece according to claim 14 and a device for detecting at least one process parameter according to claim 15.

### Technological background

Sensors and actuators, e.g. based on silicon MEMS (micro-electromechanical systems) processing, are widely used in automotive, consumer electronics, industrial control, and other fields. This includes high-pressure applications (greater than 100 MPa) using high-pressure specific packaging solutions. To withstand these high pressures, full support of the backside of the chip is favorable, to guarantee sufficient spreading of the mechanical load. In addition, for some industrial applications, e.g. sensors for monitoring a cavity in an injection mold or devices for marking work pieces in injection molding or other high-pressure forming processes, it is mandatory that the surface of the chip is close contact to the environment and forms a flat surface with the surrounding housing. Thus, classical contacting solutions as top-face bonding pads or through substrate vias are not suited for these applications. In prior art, there are solutions for side-face electrical connections, solving some problems. However, the number of electrical connections is often limited in these packages, specifically if a small packaging size is needed.

Several possibilities of forming side face electrodes have been disclosed in the past, often in conjunction with the aim to reduce the size of the package use.

JPH0738217 A discloses a ceramic board with an electrode on the front and side faces capable of wire bonding. It consists of a ceramic substrate, with a plurality of through holes, filled with a conductive thick film material, and being cut through the centre of a plurality of through holes, where the cutting surface leading to a plurality of interconnected electrodes on the side face.

US2015279562 A1 discloses a multilayer ceramic electronic component having outer electrodes that each include an end-face outer electrode disposed on an end face and connected via a sputtered side face electrode, by means of decreasing the thickness of the finished product as much as possible.

At least one drawback of the known solutions is that the density of side electrodes is rather low, thus the disclosed solutions are not suitable for a complex network of connections with a complex external device.

### Presentation of the invention

One of the objects of the invention is to avoid at least one of the disadvantages of prior art. The aim is to create an enhanced device suitable for high-pressure applications, which allows a high number of connectors for a control unit.

This task is achieved by means of the features of the independent claims. Favourable further embodiments are shown in the figures and in the dependent claims.

According to a first aspect of the invention a multilayer ceramic electronic device for contacting a control unit with an electric component or structure, comprises several ceramic layers, wherein said several ceramic layers forming a body and at least some of the ceramic layers comprise inner-layer conductive tracks. Alternatively, or additionally at least some of the ceramic layers comprise inner-layer vertical connections to neighbouring ceramic layers. At least one ceramic layer comprises at least two outer electrodes disposed on a side-face of the at least one ceramic layer, whereby said at least two outer electrodes are horizontally shifted from each other, and are electrically connected to at least one inner-layer vertical connections of neighbouring ceramic layers. At least one of the ceramic layers provides a top-layer comprising several inner-layer vertical connections for connecting at least one electrical component or structure, whereby the outer electrodes of the at least one ceramic layer are connected to some of the several inner-layer vertical connections of the top-layer.

The several inner-layer vertical connections of the top-layer act like contact pads for electrical components or structures. The device is suitable for compact packaging of interconnects and suitable for high-pressure applications, and comprises a multilayer ceramic chip formed by stacking ceramic layers with inner-layer conductive tracks, and outer electrodes disposed on side-faces so as for the ceramic chip with a surface electrode to be electrically connected on side-faces.

Said top-layer comprises just the several inner-layer vertical connections and is free of any outer electrode disposed on a side-face of the top-layer. Said device is constructed to withstand in high-pressure applications, e.g. injection molding, and being able to handle a high number of electrical connections in a compact package. Furthermore, this package allows the electrical chip to form a flat surface with the surrounding housing, thus being suitable for marking applications in injection molding.

The configuration of the multilayer ceramic electronic device offers several advantages. (i) the high number of contact pads formed as described above is suitable for applications using a high number of electrical connections, (ii) no contact pads are needed on the backside of the chip, allowing full mechanical support of the chip as needed for high-pressure applications, and (iii) the side-face outer electrodes allow a compact package, where the chip surface and the surrounding housing may form a flat surface as needed e.g. for marking or sensing applications in injection molding.

The body is preferably a stacked body. Said several ceramic layers comprise inner-layer conductive tracks, and alternatively or additionally, comprising inner-layer vertical connections to neighbouring ceramic layers and form the stacked body. The inner-layer conductive tracks and vertical connections may be formed on each ceramic layer separately. These ceramic layers are stacked together in a further stage of the process.

In another embodiment at least one ceramic layer comprises a first outer electrode disposed on a side-face of the at least one ceramic layer, wherein the first outer electrode disposed on the side-face of the at least one ceramic layer is vertically shifted with respect to the first outer electrode disposed on the side-face of a neighboured ceramic layer.

A neighboured ceramic layer of a first ceramic layer is on the one hand side an immediate neighboured layer, or a neighboured ceramic layer spaced apart from the first ceramic layer, at least by another ceramic layer. In this embodiment said first outer electrode disposed on the side-face of the first ceramic layer is vertically shifted with respect to the first outer electrode disposed on the side-face of a neighboured ceramic layer, whereby those outer electrodes are electrical insulated from each other. Thus, a very compact arrangement of outer electrodes is formed. In particular, an intermediate layer is arranged between said first ceramic layer and said immediate neighboured layer, which electrically separates the outer electrodes of the immediate neighboured layers. Said intermediate layer may comprise inner-layer conductive tracks and, alternatively or additionally, may comprise inner-layer vertical connections and preferably may not comprise any outer electrode. Preferably, said intermediate layer is made from the same ceramic material as the other layers, or may comprise a different material, like a plastic material. The intermediate layer provides a further structural separation of the ceramic layers with outer electrodes. Thus, the inner-layer connection structure may comprise a complex structure, which enhance the usage flexibility of the device.

In another embodiment at least one of the ceramic layers comprises a second outer electrode disposed on a side-face of the at least one ceramic layer, wherein the second outer electrode is vertically shifted with respect to the first outer electrode disposed on the side-face of a neighboured ceramic layer. Thus, a complex conductive network is established, which allows several possibilities to contact a control unit to the multilayer ceramic electronic device.

In another embodiment at least one of the ceramic layers comprises a first outer electrode on a first side-face and a second outer electrode on a second side-face to increase the possibilities for connection the device. Preferably several ceramic layers comprise several outer electrodes on their side-faces to further increase the possibility to wire the multilayer ceramic electronic device with a control unit.

Preferably, some of the outer electrodes of at least one of the ceramic layers are connected to each other by said inner-layer conductive tracks. Preferably, some of the outer electrodes of at least one of the ceramic layers are connected to each other by said inner-layer conductive tracks and inner-layer vertical connections. These arrangements of the conductive tracks and vertical connections create a complex inner network, which enhances the flexibility for connecting a control unit. Through the inner conductive network, the side face electrodes may be connected to the front side or the back side of the body. Additional process steps on the front- or backside of the chip, e.g. thin film processes or screen printing, may be used to add further functionality to the chip.

In one embodiment the top-layer may comprise a thin-film layer stack. The thin-film layer stack might have multiple layers, typically between 1 and 100 layers, preferably between 1 and 10 layers. Preferably the thin-film layers add a specific functionality to the device surface, e.g. sensors, actuators or heaters. The thin-film layer stack may be process on top of the top-layer. In addition, the surface might be covered with a hard coating layer to protect the underlaying layers. The hard coating layer might also be structured with a certain topography.

According to one embodiment the top-layer comprises a surface flatness smaller than 10 µm, preferably smaller than 5 µm, and a surface roughness smaller than 1 µm, preferably smaller than 0.2 µm. The particularly low surface flatness and surface roughness improves the quality of the subsequently added thin-film layer stack.

In another embodiment the first outer electrode disposed on the side-face of a first ceramic layer is horizontally shifted with respect to the first outer electrode on the side-face of a neighbouring ceramic layer. Thus, sufficient space is provided to contact the first outer electrode disposed on the side-face of the first ceramic layer and the first outer electrode on the side-face of the neighbouring ceramic layer each with a wire with the control unit. Preferably, at least one ceramic layer comprises at the same side-face more than one outer electrode, which are horizontally shifted. Using several of these ceramic layers stacked to each other, enables a stacked in a staggered pattern, to form a chessboard. This creates a regular pattern on which the wires can be arranged easily and securely in position.

According to one embodiment of the invention at least one side-face of the at least one ceramic layer comprises a surface roughness smaller than 5 µm. The particularly low surface roughness allows a better bonding of the connection and mechanical loosening of the connections is prevented. Preferably the at least one side-face of the at least one ceramic layer comprises a surface roughness between 0.1 and 3 µm. The surface with particularly low surface roughness allows enhanced wire-bonding. The surface of the exposed vertical outer electrodes is especially processed to allow enhanced wire-bonding, e.g. using Au-wires, Al-wires or ribbons. This can be achieved through mechanical processing, like grinding or polishing of the surface or through adding additional conductive material e.g. through screen printing, electroplating, or electroless deposition of metals. Instead of wire-bonding, other methods for generating electrical contacts, like soldering, structured isotropic conducting elastomers or adhesives, or unstructured anisotropic conducting elastomers or adhesives may be used.

In another embodiment at least one of the ceramic layers comprises a low temperature cofired ceramic (LTCC) or a high temperature cofired ceramic (HTCC). More specifically, this device consists of a multilayer ceramic substrate (e.g. low temperature cofired ceramics LTCC or high temperature cofired ceramics HTCC). This substrate may have a complex inner conductive network. This is formed by through holes filled with a conductive material, leading to vertical conductive lines, applied to some of the ceramic layers prior to sintering, and horizontal conductive lines applied to each layer prior to sintering.

In another embodiment at least one outer electrode disposed on the side-face of a ceramic layer is processed by a dicing process. Said dicing process exposes the outer electrodes. Some of the vertical conductive lines are exposed by a dicing process, in which dice are singulated from the substrate. To allow tolerances for the dicing process, the oval vias may be used or two vias in adjacent layers might be used, whereby these two vias show a slight offset to each other. Each dice may show a multitude of exposed vertical conductive lines, which may serve as contact pads for further electrical connections e.g. through wire-bonding of soldering. A high contact density can be reached by shifting the position of the vias from line to line. The vertical conduction lines do not peel off when connected with the control unit, thus no problem of low reliability of the connection appears.

In another embodiment said top-layer is suitable for connecting at least one electrical component like a marking component or a sensor component. Alternatively or additionally a thick film or thin film structure is applied to the top layer, which provides a sensor and / or actuator. Preferably said top-layer forms a MxN matrix or NxN matrix of vertical connections e.g. several electrodes, which are connected by the inner-layer conductive tracks, and alternatively or additionally, by the inner-layer vertical connections to at least one of the first outer electrode disposed on the side-face of the first ceramic layer and one of the first outer electrode disposed on the side-face of a neighboured ceramic layer. Thus, a huge amount of electronic devices, like sensors or heating elements or heating structures or sensor structures, contacted by the electrodes at the top-layer is easily contactable by the outer electrodes with a control unit, which forms a compact electronic chip.

In another embodiment at least one of the ceramic layers provides a bottom-layer. Said substrate covers the inner-layer conductive tracks and vertical connections of the above arranged ceramic layers. Thus, the inner-layer conductive tracks and vertical connections are physically protected.

Said bottom-layer comprising preferably a mounting surface for mounting body. Said multilayer ceramic device can be mounted reproducibly on a supporting body. Thus, a tiny embodiment of said multilayer ceramic device can be easily handled during fabrication the device.

Alternatively, said bottom-layer comprises a connection surface for a control unit. A control unit for controlling a complex device like a heating application with more than 30 heating elements, e.g. disclosed in EP 3 159 131 B1, has to be position-safely connected. Said control unit can be easily connected to the multilayer ceramic device disclosed herein.

In another embodiment at least the body is partly covered by a supporting body. At least the surface ceramic layer is just partly covered by the supporting body. Thus, the handling of the multilayer ceramic device is enhanced during injection molding.

At least the body is partly covered by a metal body. An enhanced heat exchange is provided, especially during injection molding processes.

Another aspect of the invention is a method for fabricating a multilayer ceramic electronic device, said method comprising at least the following steps:
a) Providing at least one ceramic layer comprises at least two vertical connections, whereby said at least two vertical connections are horizontally shifted from each other,
b) Providing a top-layer comprising several inner-layer vertical connections for connecting at least one electrical component or structure, whereby the vertical connections of the at least one ceramic layer are connectable to some of the several inner-layer vertical connections of the top-layer.
c) Dicing at least the first ceramic layer and the top-layer along a dicing line to separate at least a first die from both the first ceramic layer and the top-layer, whereby said dicing line is placed in the region of at least two of the vertical connections of the at least one ceramic layer to form at least two outer electrodes disposed on a side-face of the ceramic layer, whereby the outer electrodes of the at least one ceramic layer are internally connected to some of the several inner-layer vertical connections of the top-layer.

With this method a multilayer ceramic electronic device is fabricated, which offers several advantages. (i) the high number of contact pads formed as described above is suitable for applications using a high number of electrical connections, (ii) no contact pads are needed on the backside of the device, allowing full mechanical support of the chip as needed for high-pressure applications, and (iii) the side-face electrodes allow a compact package, where the chip surface and the surrounding housing may form a flat surface as needed e.g. for marking or sensing applications in injection molding. Preferably said method provides a ceramic electronic device disclosed above.

In another embodiment of the method, before step c), at least the provided first ceramic layer and the top-layer are stacked together to provide a multilayer stack. In another embodiment several ceramic layers and the top-layer are stacked together to provide a multilayer stack.

The multilayer stack is preferably formed by a sintering process. Sintering is the process of compacting and forming a solid body of material by pressure or heat without melting the materials to the point of liquefaction. The nanoparticles in the sintered material diffuse across the boundaries of the particles, fusing the particles together and creating a solid piece. Sintering is considered successful when the process enhances properties such as strength, electrical conductivity, translucency and thermal conductivity.

In another embodiment of the method, after step c), at least one surface of an outer electrode of one of the ceramic layers is processed. Said processing enhancing the surface of the outer electrode, e.g. at least one side-face of the at least one ceramic layer comprises a surface roughness smaller than 5 µm. The particularly low surface roughness allows a better bonding of the connection and mechanical loosening of the connections is prevented.

In another embodiment of the method, after step c), at least the top-layer is processed. Said processing enhancing the surface of the top-layer, finally comprising a surface flatness smaller than 10 µm, preferably smaller than 5 µm, and a surface roughness smaller than 1 µm, preferably smaller than 0.2 µm. The particularly low surface flatness and surface roughness improves the quality of the subsequently added thin-film layer stack. This can be achieved through mechanical processing, like grinding or polishing of the surface or through adding additional material e.g. through screen printing or spin coating. Preferably at least one surface of an outer electrode of one of the ceramic layers is processed to allow wire-bonding. The surface of the exposed vertical outer electrodes is especially processed to allow wire-bonding, e.g. using Au-wires, Al-wires or ribbons. This can be achieved through mechanical processing, like grinding or polishing of the surface or through adding additional conductive material e.g. through screen printing, electroplating, or electroless deposition of metals. Instead of wire-bonding, other methods for generating electrical contacts, like soldering, structured isotropic conducting elastomers or adhesives, or unstructured anisotropic conducting elastomers, or adhesives may be used.

In another embodiment of the method, after step c), at least one outer electrode of one of the ceramic layers is connected to an electrical component or structure. Thus, a multilayer ceramic electronic device is provided for a complex and multifunctional application field, which is suitable for a sensing device or a marking device.

A further aspect of the invention is a device for marking a work piece in an injection molding process comprising at least one heating electrode and at least one multilayer ceramic device disclosed herein, wherein at least one heating electrode is connected to at least one outer electrode of at least one ceramic layer. This device provides an application for marking a work piece that is at least partially formed or reshaped through a thermal process, where the marking takes place directly during the fabrication of the workpiece.

In another embodiment the top layer allows the arrangement of heating elements or heating structures. To be able to provide a 2D code with a high information density (e.g. following the DataMatrix standard) a high number of pixels and thus electrical connections are needed on a surface layer of the device.

A further aspect of the invention is a device for detecting at least one process parameter comprising at least one sensor and at least one multilayer ceramic device disclosed herein, wherein the at least one sensor is connected to at least one outer electrode of at least one of the ceramic layers.

In another embodiment the top layer allows the arrangement of multiple sensor elements or structures. These multiple sensors may detect several physical parameters. Thus, a multisensing device is provided, which is compact.

Further advantages, features and details of the invention result from the following description, in which exemplary embodiments of the invention are described with reference to the drawings.

The reference list is also an integral part of the disclosure like the technical content of the patent claims and figures are. The figures are comprehensively described in relation to one another. Identical reference numbers denote identical components, and reference numbers having different indices indicate functionally identical or similar components.

By means of the following figures, the invention is explained in more detail by means of exemplary embodiments. The reference list is part of the disclosure.

Position information, such as "above", "below", "right" or "left" are each related to the corresponding representations and are not to be understood as restrictive.

Although the invention is represented and described in detail by means of the figures and the corresponding description, this representation and this detailed description are illustrative and exemplary and not restrictive of the invention. It is to be understood that professionals can make changes and modifications without leaving the scope of the following claims. In particular, the invention also comprises embodiments with any combination of features mentioned or shown above for various aspects and/or embodiments.

The invention also comprises individual features in the figures, even if they are shown there in connection with other features and/or are not mentioned above. Furthermore, the term "comprise", and derivatives thereof does not exclude other elements or steps. Likewise, the indefinite article "a" and "an" and derivatives thereof do not exclude a plurality. The functions of a plurality of features listed in the claims may be fulfilled by a single unit. The terms "essentially", "about", "approximately" and the like in connection with a property or a value also define, in particular, exactly the property or exactly the value. All reference numbers in the claims are not to be understood as limiting the scope of the claims.

### Description of the figures

The figures are comprehensively described in relation to one another. The same reference numbers mean the same components. The figures show
Fig. 1: several ceramic layers of a first embodiment of the inventive multilayer device, in a perspective view,
Fig. 2: said several ceramic layers according to Fig. 1 adjacent to each other, in a perspective view,
Fig. 3: said several ceramic layers according to Fig. 2 after a sintering process, in a perspective view,
Fig. 4: an array of multilayer ceramic devices according to Fig. 1 in a perspective view,
Fig. 5: a second embodiment of the inventive multilayer device, in a perspective view,
Fig. 6: several ceramic layers of a third embodiment of the inventive multilayer device, in a perspective view,
Fig. 7: said several ceramic layers according to Fig. 6 adjacent to each other, in a perspective view,
Fig. 8: said several ceramic layers according to Fig. 7 after a sintering process, in a perspective view,
Fig. 9: a first embodiment of an inventive device for detecting at least one process parameter comprising three sensors, which are arranged on the multilayer ceramic device according to Fig. 1
Fig. 10: the device according to Fig. 9 with a control unit connected to the sensors, in a side view,
Fig. 11: said device according to Fig. 9 with a housing, in a side view, and
Fig. 12: said device according to Fig. 9 with a thin film layer stack on the top-layer, in a side view.

### Embodiment of the invention

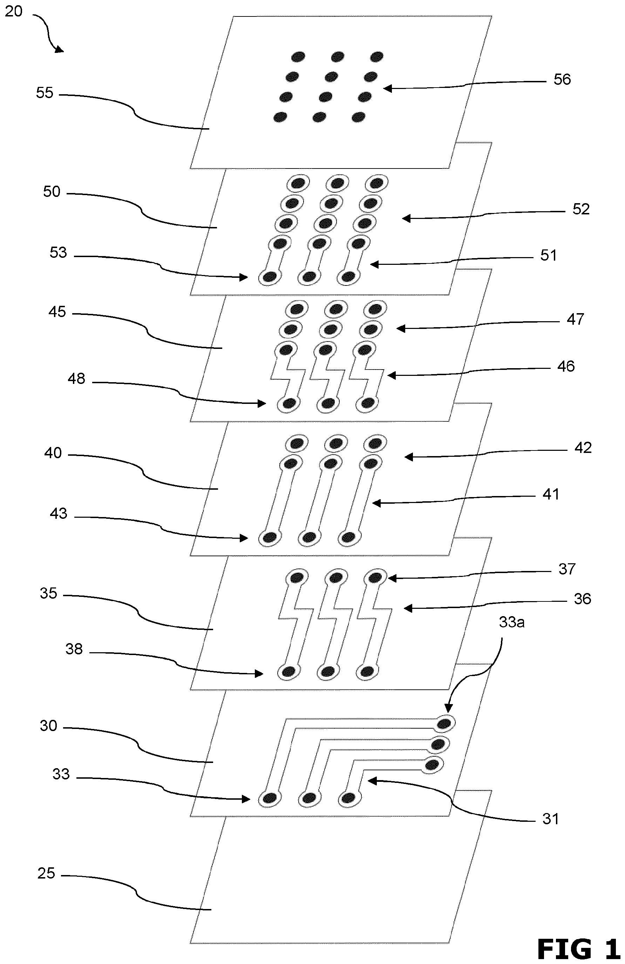

**Figure 1 to Figure 3** show a first embodiment of a multilayer ceramic electronic device 20 for contacting a control unit with an electric component or structure comprising several ceramic layers 25, 30, 35, 40, 45, 50, 55. The top-most ceramic layer 55 is a top-layer comprising several inner-layer vertical connections 56, forming a four times three matrix, and the bottom-most ceramic layer 25 is a ceramic substrate. The inner ceramic layers 30, 35, 40, 45, 50 comprise several inner-layer conductive tracks 31, 36, 41, 46, 51 and inner-layer vertical connections 37, 42, 47, 52 to their neighbouring ceramic layers and each of them comprise several vertical connections 33, 38, 43, 48, 53 which are shifted horizontally and alternating from left to right from one ceramic layer to another ceramic layer. The ceramic layers 25, 30, 35, 40, 45, 50, 55 comprise a low temperature cofired ceramic (LTCC).

The ceramic layer 30 comprises three bend inner-layer conductive tracks 31, and six vertical connections 33, 33a, which are connectable with said vertical connections 33, 38, 43, 48, of the inner ceramic layers 30, 35, 40, 45. The vertical connections 33, 33a are placed at the ceramic layer 30 without any connection to a vertical connection of the ceramic layers 30, 35, 40, 45.

The ceramic layer 35 comprises three bend inner-layer conductive tracks 36 and three inner-layer vertical connections 37 and vertical connections 38, which are horizontally shifted to the vertical connections 33 of the neighboured ceramic layer 30. Each bend inner-layer conductive track 36 connects an inner-layer vertical connection 37 with a vertical connection 38.

The ceramic layer 40 comprises three straight inner-layer conductive tracks 41 and six inner-layer vertical connections 42 and vertical connections 43. Each straight inner-layer conductive track 41 connects an inner-layer vertical connection 42 with a vertical connection 43. The vertical connections 43 are congruent with the vertical connection 33 of the neighboured ceramic layer 30.

The ceramic layer 45 comprises three bend inner-layer conductive tracks 46 and nine inner-layer vertical connections 47 and vertical connections 48, which are horizontally shifted to the vertical connections 33 of the neighboured ceramic layer 30. Each bend inner-layer conductive track 46 connects an inner-layer vertical connection 47 with a vertical connection 48. The vertical connections 48 are congruent with the vertical connection 38 of the neighboured ceramic layer 35.

The ceramic layer 50 comprises three straight inner-layer conductive tracks 51 and twelve inner-layer vertical connections 52. Each straight inner-layer conductive track 51 connects an inner-layer vertical connection 52 with a vertical connection 53. The vertical connections 53 are congruent with the vertical connection 43 of the neighboured ceramic layer 40.

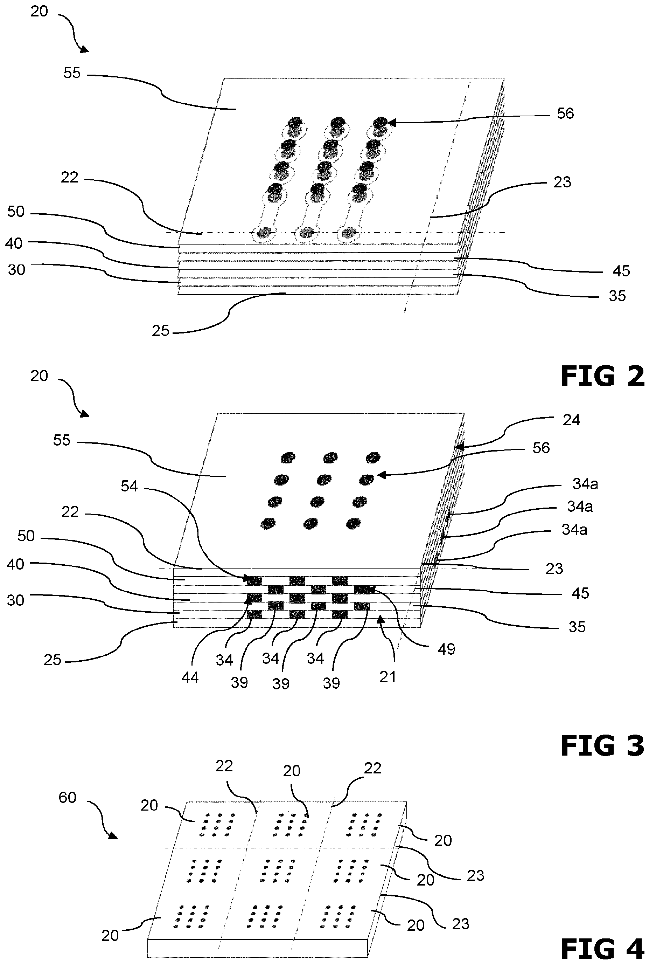

**Figure 2** shows the several ceramic layers 25, 30, 35, 40, 45, 50, 55 stacked together to a body. In this arrangement at least one of the inner-layer vertical connections 37, 42, 47, 52 is vertically connected with another of the inner-layer vertical connections 37, 42, 47, 52 and drained to one of the three vertical connections 38, 43, 48, 53.

The multilayer ceramic device 20 comprises two dicing lines 22, 23, which are generally virtual lines, placed above the centre of the vertical connections 33, 38, 43, 48, 53 and the vertical connections 33a of the ceramic layer 30. Said stacked body is formed by a sintering process and afterwards the multilayer ceramic device 20 is diced with a dicing saw or another apparatus for separation (e.g. laser) along the dicing lines 22, 23. The cut-off pieces of the device 20 are waste.

**Figure 3** shows the multilayer ceramic device 20 after the dicing process. Each ceramic layer comprise three outer electrodes 34, 39, 44, 49, 54 disposed on the side-face of the respective ceramic layer 30, 35, 40, 45, 50, wherein the outer electrodes 34, 39, 44, 49, 54 disposed on the side-face of a first ceramic layer are vertically and horizontally shifted with respect to the outer electrodes disposed on the side-face of a neighboured ceramic layer. The ceramic layer 30 comprises first outer electrodes 34 on a first side-face 21 and second outer electrodes 34a on second a side-face 24.

The embodiment of the multilayer ceramic device 20 according to **Figure 1** to **Figure 3** is produced in a simple process. To fabricate many of those multilayer ceramic devices 20 it is advantageous to sinter several of those multilayer ceramic devices 20 on large ceramic layers, forming an array 60 next to each other, and dice the multilayer ceramic devices 20 along the dicing lines 22, 23 - see **Figure 4****.** This allows parallel manufacturing of many devices 20. Preferably, additional process steps on the front- or backside of the array 60, e.g. lapping, polishing, thin film processes or screen printing, used to add further functionality to the device, are added before singulating them.

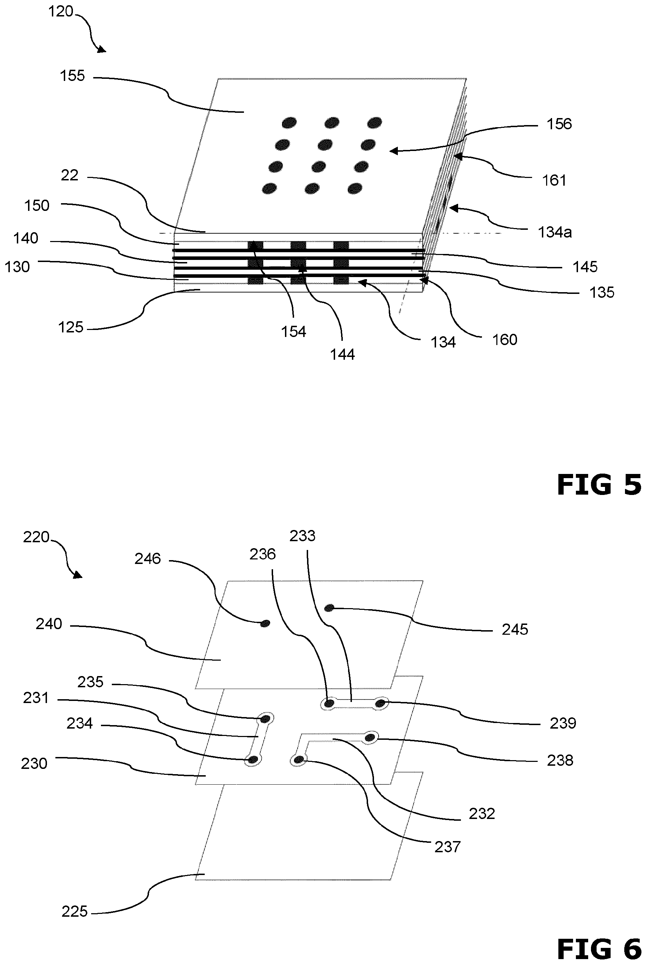

**Figure 5** shows a second embodiment of a multilayer ceramic electronic device 120 for contacting a control unit with an electric component comprises several ceramic layers 125, 130, 135, 140, 145, 150, 155. The top-most ceramic layer 155 is a top-layer comprising several inner-layer vertical connections 156, forming a four times three matrix, and the bottom-most ceramic layer 125 is a ceramic substrate without any vertical connections. The inner ceramic layers 130, 135, 140, 145, 150 comprise several inner-layer conductive tracks and inner-layer vertical connections as already disclosed for the multilayer ceramic device 20 according to **Figure 1** to **Figure 3****.** Here, the ceramic layers 135, 145 are intermediate layers and without comprising outer electrodes and are arranged between the ceramic layers 130, 140, 150, which do comprise outer electrodes 134, 134a, 144, 154. After the dicing process, each ceramic layer 130, 140, 150 comprise three outer electrodes 134, 144, 154 disposed on the first side-face 160 of the respective ceramic layer 130, 140, 150 wherein the outer electrodes 134, 144, 154 disposed on the first side-face 160 of the ceramic layers 130, 140, 150 are vertically shifted with respect to the outer electrodes 134, 144, 154 disposed on the side-face 160 of the spaced apart neighboured ceramic layer. The ceramic layer 130 comprises first outer electrodes 134 on first the side-face 160 and second outer electrodes 134a on the second side-face 161. The ceramic layers 130, 140, 150 comprise a high temperature cofired ceramic (HTCC).

**Figure 6 to Figure 8** show a third embodiment of a multilayer ceramic electronic device 220 for contacting a control unit with an electric component, e.g. a sensor, comprising several ceramic layers 225, 230, 240. The top-most ceramic layer 240 is a top-layer comprises two inner-layer vertical connections 245, 246 and the bottom-most ceramic layer 225 is a ceramic substrate. The inner ceramic layer 230 comprises three inner-layer conductive tracks 231, 232, 233 and several inner-layer vertical connections 234, 235, 236, 237, 238, 239.

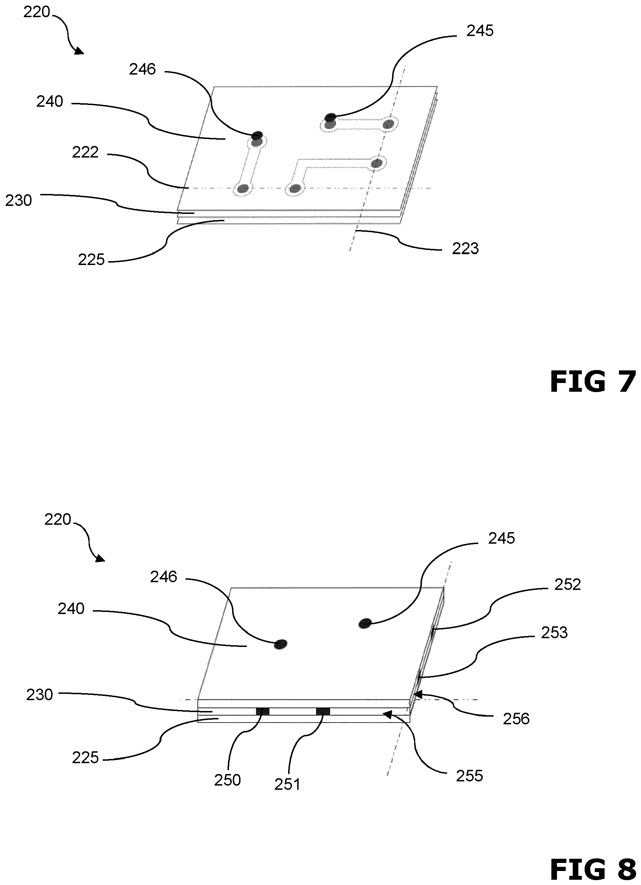

**Figure 7** shows the several ceramic layers 225, 230, 240 stacked together to a body. In this arrangement the inner-layer vertical connections 245, 246 are vertically connected with two inner-layer vertical connections 235, 236 and drained to the vertical connections 234, 239 by the inner-layer conductive tracks 231, 233. The inner-layer vertical connections 237, 238 are drained by the inner-layer conductive track 232. The multilayer ceramic device 220 comprises two dicing lines 222, 223, which are generally virtual lines, placed above the centre of the vertical connections 234, 237, 238, 239. Said stacked body is formed by a sintering process and afterwards the multilayer ceramic device 220 is diced with a dicing saw or an other apparatus for separation (e.g. laser) along the dicing lines 222, 223. The cut-off pieces of the device 220 are waste.

**Figure 8** shows the multilayer ceramic device 220 after the dicing and sintering process. The sandwiched ceramic layer 230 comprise two outer electrodes 250, 251 disposed on the first side-face 255 and two second outer electrodes 252, 253 disposed on the second side-face 256. The two outer electrodes 250, 251 disposed on the first side-face 255 are horizontal shifted and the two outer electrodes 252, 253 disposed on the second side-face 256 are horizontal shifted.

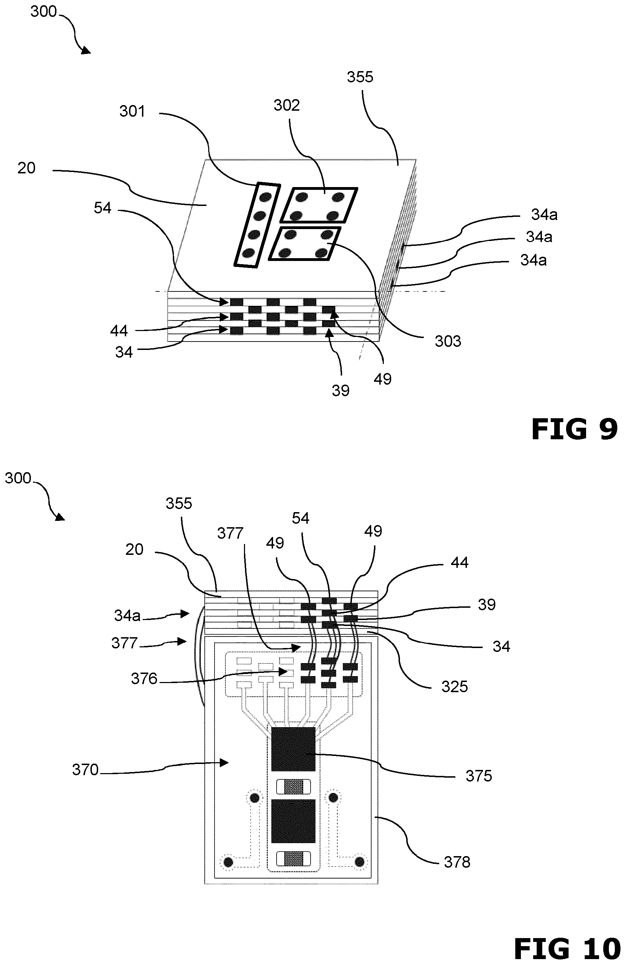

**Figure 9** to **Figure 12** show a first embodiment of the inventive device 300 for detecting at least one process parameter comprising three sensors 301, 302, 303, which are arranged on the multilayer ceramic device 20 according to **Figure 1 to Figure 3****.** The multilayer ceramic device 20 is connected to an electric circuit board 370 via the outer electrodes 34, 39, 44, 49, 54 on the side-face of the device 20. The electric circuit board 370 is placed on supporting body 378, on which the bottom connection surface layer 325 is attached. The electric circuit board 370 comprises electronics elements 375 (e.g. an integrated circuit) and several circuit board electrodes 376 which are electrically connect to the outer electrodes 34, 39, 44, 49, 54 of the multilayer ceramic device 20 using several wires 377. These outer electrodes 34, 39, 44, 49, 54 are internal connected to the three sensors 301, 302, 303. In one possible embodiment this electric circuit board 370 connects the device 20 to a further control unit, e.g. via a cable or wireless communication. In another possible embodiment, this electric circuit board 370 contains electronic elements 375, which form a logic circuit, e.g. for signal processing, instrumentation and control. This functionality might be in addition to the connection functionality.

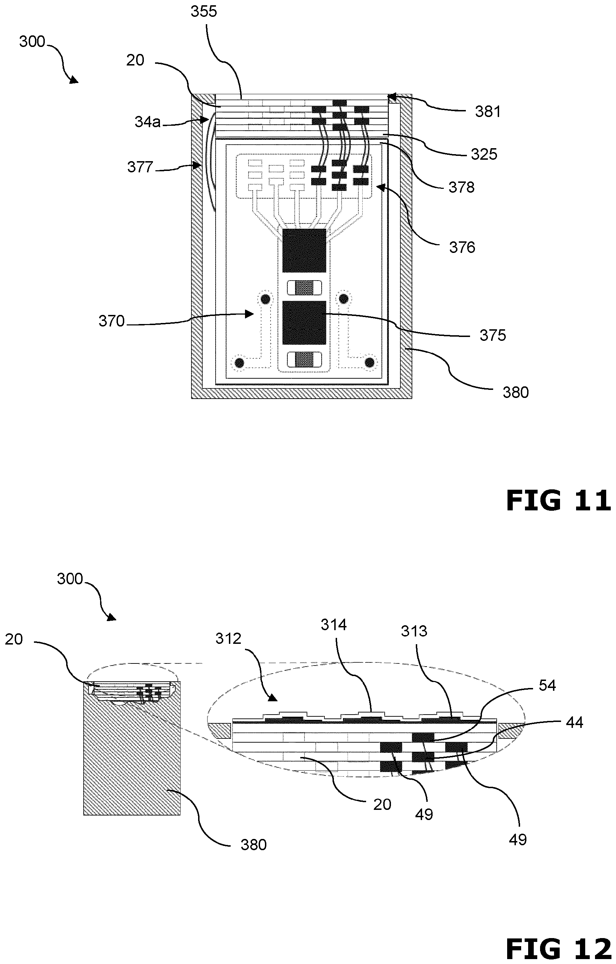

The bottom layer 325 is free of outer electrodes and is directly mounted to a supporting body 378. The supporting body 378 is covered by a housing 380. The housing 380 protects the package and the device 20 from the environment. This housing comprises an opening 381, allowing direct contact of the die top-layer 355 to the environment - see **Figure 11****.**

**Figure 12** shows the top-layer processed with a thin-film process on top of a substrate of the device 300, providing a thin-film layer stack 312. The layer stack 312 have multiple layers 313, typically between 1 and 10 layers. The thin-film layers 313 add a specific functionality to the device surface, e.g. sensors, actuators or heaters. In addition, the surface is covered with a hard coating layer 314 to protect the underlaying layers 313. The hard coating layer 314 might also be structured with a certain topography.

A first embodiment of a method for fabricating a ceramic electronic device 20 is disclosed using the **Figure 1** to **Figure 3****.** Said method comprising at least the following steps:
a) Providing several ceramic layers 30, 35, 40, 45, 50 comprises inner-layer vertical connections 37, 42, 47, 52 and vertical connections 33, 38, 43, 48, 53 whereby said inner-layer vertical connections 37, 42, 47, 52 are horizontally shifted from each other,
b) Providing a top-layer 55 comprising several inner-layer vertical connections 56 for connecting at least one electrical component, whereby the inner-layer vertical connections 37, 42, 47, 52 of the ceramic layers 35, 40, 45, 50 are connectable to some of the several inner-layer vertical connections 56 of the top-layer 55.
c) Dicing the ceramic layers 25, 30, 35, 40, 45, 50 and the top-layer 55 along dicing lines 22, 23 to separate at least a first die from both the ceramic layers 25, 30, 35, 40, 45, 40 and the top-layer 55, whereby said dicing lines 22, 23 are placed in the region of the inner-layered vertical connections 37, 42, 47, 52 of the ceramic layers to form at least two outer electrodes 34, 39, 44, 39, 54 disposed on one side-face 21 of the ceramic layer, whereby the outer electrodes 34, 39, 44, 39, 54 of the ceramic layer 35, 40, 45, 50 are internally connected to some of the several inner-layer vertical connections 56 of the top-layer 55.

Before step c), at least the provided first ceramic layer 25, 30, 35, 40, 45, 50 and the top-layer 55 are stacked together to provide a multilayer stack. The multilayer stack is formed by a sintering process.

A step c), at least one surface of an outer electrode 34, 39, 44, 49, 54 of one of the ceramic layers is processed. Said processing enhancing the surface of the outer electrode 34, 39, 44, 49, 54, e.g. at least one side-face 21 of the at least one ceramic layer 30, 35, 40, 45, 50 comprises a surface roughness smaller than 5 µm. The particularly low surface roughness allows a better bonding of the connection and mechanical loosening of the connections is prevented.

Preferably at least one surface of an outer electrode 34, 39, 44, 49, 54 of one of the ceramic layers 30, 35, 40, 45, 50 is processed to allow wire-bonding. The surface of the exposed vertical outer electrodes 34, 39, 44, 49, 54 are especially processed to allow enhanced wire-bonding, e.g. using Au-wires, Al-wires or ribbons. This can be achieved through mechanical processing, like grinding or polishing of the surface or through adding additional conductive material e.g. through screen printing, electroplating, or electroless deposition of metals. Instead of wire-bonding, other methods for generating electrical contacts, like soldering, structured isotropic conducting elastomers or adhesives, or unstructured anisotropic conducting elastomers or adhesives may be used.

After step c), at least one outer electrode 34, 39, 44, 49, 54 of one of the ceramic layers is connected to an electrical component. Thus, a multilayer ceramic device 20 is provided for a complex and multifunctional application field, which is suitable for a sensing device or a marking device.

### Reference list

- 20: multilayer ceramic electronic device
- 21: first side face
- 22: dicing lines
- 23: dicing lines
- 24: second side face
- 25: bottom layer
- 30: ceramic layer
- 31: inner-layer conductive tracks
- 33: vertical connections
- 33a: vertical connections
- 34: outer electrodes
- 34a: outer electrodes
- 35: ceramic layer
- 36: inner-layer conductive tracks
- 37: inner-layer vertical connections
- 38: vertical connections
- 39: outer electrodes
- 40: ceramic layer
- 41: inner-layer conductive tracks
- 42: inner-layer vertical connections
- 43: vertical connections
- 44: outer electrodes
- 45: ceramic layer
- 46: inner-layer conductive tracks
- 47: inner-layer vertical connections
- 48: vertical connections
- 49: outer electrodes
- 50: ceramic layer
- 51: inner-layer conductive tracks
- 52: inner-layer vertical connections
- 53: vertical connections
- 54: outer electrodes
- 55: ceramic layer/ top layer
- 56: inner-layer vertical connections

- 120: multilayer ceramic electronic device
- 125: ceramic layer / bottom layer
- 130: ceramic layer
- 134: first outer electrodes
- 134a: second outer electrodes
- 135: intermediate layer
- 140: ceramic layer
- 144: outer electrodes
- 145: intermediate layer
- 150: ceramic layer
- 154: outer electrodes
- 155: ceramic layer/ top layer
- 156: inner-layer vertical connections
- 160: first side-face
- 161: second side-face

- 220: multilayer ceramic electronic device
- 222: dicing line
- 223: dicing line
- 225: ceramic layer / bottom layer
- 230: ceramic layer
- 231: inner-layer conductive track
- 232: inner-layer conductive track
- 233: inner-layer conductive track
- 234: vertical connection
- 235: inner-layer vertical connection
- 236: inner-layer vertical connection
- 237: vertical connection
- 238: vertical connection
- 239: vertical connection
- 240: ceramic layer/ top-layer
- 245: inner-layer vertical connection
- 246: inner-layer vertical connection
- 250: outer electrode
- 251: outer electrode
- 252: outer electrode
- 253: outer electrode
- 255: first side-face
- 256: second side-face
- 300: device
- 301: sensor
- 302: sensor
- 303: sensor
- 312: layer stack
- 313: thin-film layers
- 314: hard coating layer
- 325: ceramic layer / bottom layer
- 355: ceramic layer / top layer
- 370: electric circuit board
- 375: electronic element
- 376: circuit board electrodes
- 377: wires
- 378: supporting body
- 380: housing
- 381: opening

## Claims

1. Multilayer ceramic electronic device (20; 120; 220) for contacting a control unit with an electric component or structure, comprising several ceramic layers (25, 30, 35, 40, 45, 50, 55; 125, 130, 135, 140, 145, 150; 225, 230, 240, 355), wherein said several ceramic layers forming a body and at least some of the ceramic layers comprising inner-layer conductive tracks (31, 36, 41, 46, 51; 231, 232, 233) and/or at least some of the ceramic layers comprising inner-layer vertical connections (37, 42, 47, 52, 56; 156; 235, 236, 245, 246) to neighboring ceramic layers, at least one ceramic layer comprises at least two outer electrodes (34, 34a, 39, 44, 49, 54; 134, 134a, 144, 154; 250, 251, 252, 253) disposed on a side-face (21, 24; 160, 161; 255, 256) of the at least one ceramic layer, whereby said at least two outer electrodes are horizontally shifted from each other, and are electrically connected to at least one inner-layer vertical connection of neighboring ceramic layers, **characterized in that,** at least one of the ceramic layers provides a top-layer (55; 155; 240; 355) comprising several inner-layer vertical connections (56; 156; 245, 246) for connecting at least one electrical component or structure, whereby the outer electrodes (34, 34a, 39, 44, 49, 54; 134, 134a, 144, 154; 250, 251, 252, 253) of the at least one ceramic layer are connected to some of the several inner-layer vertical connections (56; 156; 245, 246) of the top-layer (55; 155; 240; 355).

2. The device according to claim 1, **characterized in that,** at least one ceramic layer (25, 30, 35, 40, 45, 50, 55; 125, 130, 135, 140, 145, 150; 225, 230, 240, 355) comprises a first outer electrode (34; 134) disposed on a side-face (21; 160) of the at least one ceramic layer, wherein the first outer electrode (34; 134) disposed on the side-face (21; 160) of the at least one ceramic layer is vertically shifted with respect to the first outer electrode (39, 44, 49, 54; 144, 154) disposed on the side-face (21; 160) of a neighbored ceramic layer.

3. The device according to claim 1, or 2, **characterized in that,** at least one of the ceramic layers (25, 30, 35, 40, 45, 50, 55; 125, 130, 135, 140, 145, 150; 225, 230, 240, 355) comprises a second outer electrode (34; 134) disposed on a side-face (21; 160) of the at least one ceramic layer, wherein the second outer electrode (34; 134) is vertically shifted with respect to the first outer electrode (39, 44, 49, 54; 144, 154) disposed on the side-face (21; 160) of a neighbored ceramic layer.

4. The device according to the previous claims, **characterized in that,** the first outer electrode (34) disposed on the side-face (21) of a first ceramic layer is horizontally shifted with respect to the first outer electrode (39, 49, 54) on the side-face (21) of a neighboring ceramic layer.

5. The device according to the previous claims, **characterized in that,** at least one side-face (21, 24; 160, 161; 255, 256) of the at least one ceramic layer comprises a surface roughness smaller than 5 µm, preferably comprises a surface roughness between 0.1 and 3 µm.

6. The device according to the previous claims, **characterized in that,** at least one of the ceramic layers (25, 30, 35, 40, 45, 50, 55; 125, 130, 135, 140, 145, 150; 225, 230, 240, 355) comprises a low temperature cofired ceramic (LTCC) or a high temperature cofired ceramic (HTCC).

7. The device according to the previous claims, **characterized in that,** at least one outer electrode (34, 34a; 134, 134a; 39, 44, 49, 54; 144, 154; 250, 251, 252, 253) disposed on the side-face (21, 24, 160, 161, 255, 256) of a ceramic layer is processed by a dicing process.

8. The device according to the previous claims, **characterized in that,** said several inner-layer vertical connections (37, 42, 47, 52, 56; 156;, 235, 236, ) on said top-layer (55; 155; 240; 355) form a matrix of vertical connections.

9. The device according to the previous claims, **characterized in that,** at least one of the ceramic layers provides a bottom-layer (25; 125; 225), comprising preferably a mounting surface for mounting body or a connection surface for a control unit and/or at least the body is partly covered by a supporting body (378), preferably by a metal body.

10. Method for fabricating a ceramic electronic device, preferably a multilayer ceramic electronic device of one of the claims 1 to 9, said method comprising at least the following steps:
a) Providing at least one ceramic layer (25, 30, 35, 40, 45, 50, 55; 125, 130, 135, 140, 145, 150; 225, 230, 240, 355) comprises at least two vertical connections (33, 33a, 38, 43, 48, 53), whereby said at least two vertical connections are horizontally shifted from each other,
b) Providing a top-layer (55; 155; 240; 355) comprising several inner-layer vertical connections (56; 156; 245, 246) for connecting at least one electrical component or structure, whereby the vertical connections (33, 33a, 38, 43, 48, 53) of the at least one ceramic layer are connectable to some of the several inner-layer vertical connections (56; 156; 245, 246) of the top-layer (55; 155; 240; 355).
c) Dicing at least the first ceramic layer (25, 30, 35, 40, 45, 50; 125, 130, 135, 140, 145, 150; 225, 230, 240, 355) and the top-layer (55; 155; 240; 355) along a dicing line (22, 23; 222, 223) to separate at least a first die from both the first ceramic layer and the top-layer, whereby said dicing line (22, 23; 222, 223) is placed in the region of at least two of the vertical connections (33, 33a, 38, 43, 48, 53) of the at least one ceramic layer to form at least two outer electrodes (34, 34a; 134, 134a; 39, 44, 49, 54; 144, 154; 250, 251, 252, 253) disposed on a side-face of the ceramic layer, whereby the outer electrodes (34, 34a; 134, 134a; 39, 44, 49, 54; 144, 154; 250, 251, 252, 253) of the at least one ceramic layer are internally connected to some of the several inner-layer vertical connections (56; 156; 245, 246) of the top-layer (55; 155; 240; 355).

11. The method according to claim 10, **characterized in that,** before step c), at least the provided first ceramic layer (25, 30, 35, 40, 45, 50, 55; 125, 130, 135, 140, 145, 150; 225, 230, 240, 355) and the top-layer (55; 155; 240; 355) are stacked together to provide a multilayer stack, while the multilayer stack is preferably formed by a sintering process.

12. The method according to claim 10 or 11, **characterized in that,** after step c) at least one surface of an outer electrode (34, 34a; 134, 134a; 39, 44, 49, 54; 144, 154; 250, 251, 252, 253) of one of the ceramic layers is processed, preferably to allow wire-bonding.

13. The method according to one of the claims 10 to 12, **characterized in that,** after step c), at least one outer electrode (34, 34a; 134, 134a; 39, 44, 49, 54; 144, 154; 250, 251, 252, 253) of one of the ceramic layers is connected to an electrical component.

14. Device for marking a work piece in an injection molding process comprising at least one heating electrode and at least one multilayer ceramic device according to one of the claims 1 to 9, wherein at least one heating electrode is connected to at least one outer electrode of at least one ceramic layers.

15. Device for detecting at least one process parameter comprising at least one sensor and at least one multilayer ceramic device according to one of the claims 1 to 9, wherein the at least one sensor is connected to at least one outer electrode of at least one of the ceramic layers.
